Europäisches Patentamt

(19) **European Patent Office**

Office européen des brevets

(11) Numéro de publication: **0 032 083**
**A1**

(12) # DEMANDE DE BREVET EUROPEEN

(21) Numéro de dépôt: **80401790.3**

(22) Date de dépôt: **12.12.80**

(51) Int. Cl.³: **H 01 R 29/00**
**G 01 R 1/20**

(30) Priorité: **26.12.79 FR 7931648**

(43) Date de publication de la demande:
**15.07.81 Bulletin 81/28**

(84) Etats contractants désignés:
**CH DE GB IT LI SE**

(71) Demandeur: **ENERTEC SOCIETE ANONYME**
**12, Place des Etats Unis**
**F-92120 Montrouge(FR)**

(72) Inventeur: **N'Guyen, Van Lan**
**19, rue du Sud**
**F-92160 Antony(FR)**

(72) Inventeur: **Baril, Paul**
**22, rue François Miron**
**F-75004 Paris(FR)**

(74) Mandataire: **Bentz, Jean-Paul**
**GIERS SCHLUMBERGER 12, Place Des Etats Unis**
**F-92124 Montrouge Cedex(FR)**

(54) **Dispositifs de connexion électrique et d'essai.**

(57) Dispositifs pour le raccordement électrique d'appareils à des organes de mesure tels que des transformateurs, permettant également l'essai des appareils ainsi raccordés.

Un boîtier de connexion est équipé d'une première paire d'organes de connexion (14B, 14C) destinée à être raccordée à un transformateur de courant (40), une deuxième paire d'organes de connexion (14A, 14D) permettant la liaison de ce transformateur de courant à un dispositif d'exploitation, et d'une liaison interruptible (16a, 16b), entre les organes de connexion respectifs de la première paire et la seconde paire. Une prise d'essai (50) est pourvue d'organes de connexion mâles (60A, B, C, D) adaptés à coopérer avec les premier et deuxième organes de connexion du boîtier. Une liaison (68 B) faisant partie intégrante de la prise d'essai est couplée aux organes de connexion (60A, B, C, D) de la prise de façon à établir, lorsque cette prise est accouplée au boîtier, un circuit continu entre les bornes de sortie du transformateur de courant (40).

Application au raccordement et à l'essai des appareils de protection pour réseaux électriques.

./...

Fig. 6

# DISPOSITIFS DE CONNEXION ELECTRIQUE ET D'ESSAI

La présente invention est relative à des dispositifs de connexion électrique et d'essai, par exemple pour permettre de vérifier des équipements électriques tels que des relais de protection

On sait qu'un nombre considérable de relais de protection de diverses sortes sont utilisés dans les réseaux de distribution d'énergie électrique pour détecter les défauts et éviter d'endommager le réseau en prenant rapidement les dispositions nécessaires. Le fonctionnement de tels relais implique souvent un contrôle du courant ou des courants mesurés dans le réseau à l'emplacement du relais, et à cette fin le relais est en général raccordé au réseau à l'aide de dispositifs connus sous le nom de transformateurs de courant. Afin d'assurer la fiabilité d'un système de relais de protection, il est nécessaire d'essayer régulièrement chaque relais en lui appliquant des signaux d'essai représentatifs de différentes conditions de défaut possibles. Pendant ces tests, le relais est en général déconnecté de son transformateur de courant associé, mais ce dernier reste raccordé au réseau sous tension. Dans ces conditions, il est essentielque les sorties du transformateur de courant restent continuellement liées l'une à l'autre par un circuit conducteur de faible impédance, car une interruption, même de courte durée, d'un tel circuit de sortie d'un transformateur de courant sous tension, peut provoquer la désintégration explosive de ce dernier.

Différents dispositifs comportant la combinaison d'une prise et d'un boîtier de test ont été proposées pour satisfaire la susdite condition, mais chacun présente ses inconvénients propres. Ainsi, selon une disposition connue une barre de court-circuit sollicitée par un ressort maintient la continuité entre chaque borne de connexion du transformateur de courant et la borne respective du circuit de relais jusqu'à ce qu'une prise d'essai soit insérée. Cependant, la prise d'essai proprement dite comporte des organes de connexion isolés aux bornes desquels il convient de brancher une charge de court-circuitage des bornes du transformateur de courant en sorte que l'intégrité des circuits de sortie de ce transformateur dépend toujours de l'assemblage correct du circuit d'essai et est sujette aux erreurs humaines. Selon une autre disposition connue, un court-circuit direct s'établit automatiquement à l'intérieur du boîtier de test entre les organes de sortie du transformateur de courant lors de l'insertion de la prise d'essai, mais le circuit de sortie du transformateur reste totalement inaccessible à l'intérieur de l'équipement d'essai alors qu'il serait souhaitable d'y avoir accès pour effectuer certaines vérifications et réglages en y interposant un autre équipement avec les précautions appropriées.

Conformément à un aspect de l'invention, il est prévu une prise d'essai pour un dispositif de connexion électrique dans lequel un premier élément possède une première paire d'organes de connexion à un transformateur de courant et une deuxième paire d'organes de connexion à un circuit d'exploitation fonctionnant en réponse à ce transformateur de courant, chacun des organes de connexion de la première paire étant relié à un organe de connexion correspondant de la deuxième paire par une liaison interruptible respective, cette prise d'essai comportant un second élément possédant une première et une deuxième paire d'organes de connexion agencés pour venir en contact respectivement avec ladite première et seconde paire d'organes de connexion du premier élément lorsque lesdits éléments sont accouplés en fonctionnement, et des moyens pour manoeuvrer ladite liaison interruptible, cette prise étant en outre caractérisée en ce qu'elle comporte des moyens de raccordement formant partie intégrante dudit second élément et reliés à la première paire d'organes de connexion de celui-ci pour les raccorder éléctriquement l'un à l'autre au moins lorsque lesdits premier et second éléments sont accouplés; et en ce que, lorsque lesdits éléments sont progressivement accouplés, les premières paires d'organes de connexion de chacun de ces éléments entrent d'abord en contact réciproque afin d'établir par l'intermédiaire desdits moyens de raccordement un circuit continu incluant ledit transformateur de courant; puis lesdits moyens de manoeuvre agissent sur ladite liaison interruptible pour interrompre la connexion entre lesdites première et seconde paires d'organes du premier élément; puis les organes de connexion de la seconde paire de chacun desdits éléments entrent en contact réciproque.

Selon un autre aspect, l'invention concerne également un dispositif de connexion d'un appareillage électrique à un réseau adapté à être accouplé fonctionnellement avec une prise d'essai du type défini ci-dessus.

Un équipement de connexion électrique et d'essai conforme à l'invention et susceptible d'être utilisé avec un relais de protection va être maintenant décrit, à titre d'exemple, en référence aux dessins annexés dans lesquels :

la figure 1 est une vue en perspective avec des arrachés partiels d'un boîtier formant partie de l'équipement de connexion;

la figure 2 est une vue en perspective avec arrachements partiels du boîtier;

la figure 3 est une vue en perspective d'un couvercle pour le boîtier;

la figure 4 est une vue en coupe latérale du boîtier avec son couvercle;

la figure 5 est une vue en perspective avec arrachement partiel d'une prise d'essai destinée à être utilisée avec le boîtier;

les figures 6 et 7 sont des vues latérales en coupe partielle schématiques illustrant les étapes successives de l'insertion de la prise d'essai dans le boîtier; et

la figure 8 représente schématiquement un autre agencement général possible pour un équipement selon l'invention.

L'équipement de connexion et d'essai qui va être maintenant décrit est destiné à être utilisé avec un relais de protection surveillant des signaux d'entrée en provenance de transformateurs de courant et de transformateurs de tension raccordés à un réseau de distribution d'énergie électrique polyphasé pour fournir des signaux de sortie pour la commande éventuelle d'un disjoncteur. Lorsque le relais doit être essayé, il est nécessaire d'inhiber l'émission desdits signaux de sortie, de débrancher la connexion entre le relais et les transformateurs de courant et de tension, tout en maintenant cependant une liaison à basse impédance dans le circuit de sortie du transformateur de courant.

Cette liaison doit également être maintenue pendant les phases ultérieures de branchement et de mise en oeuvre de l'équipement d'essai.

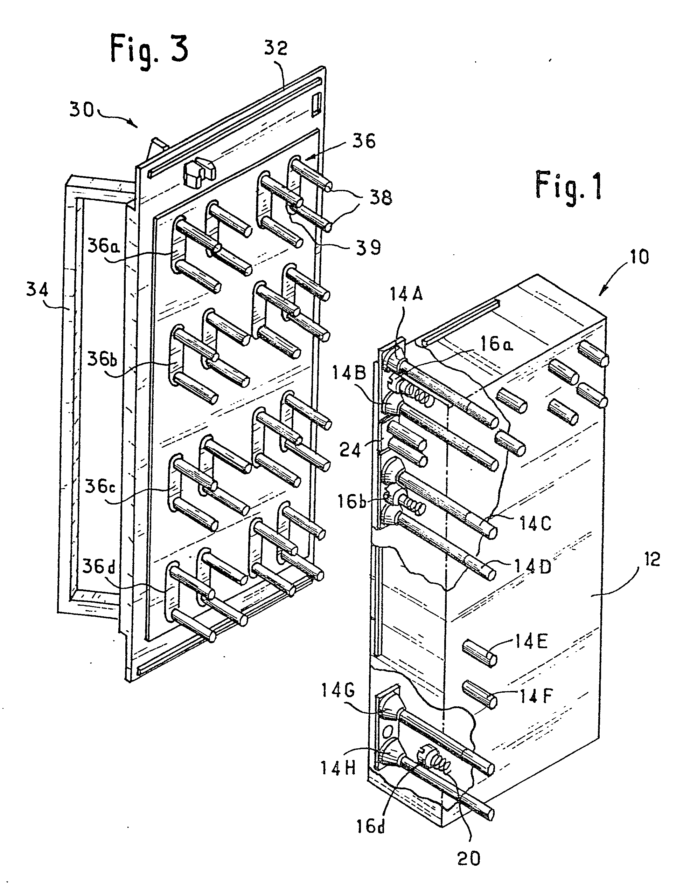

En se référant maintenant aux figures 1, 2 et 4, un boîtier de connexion et d'essai est désigné d'une façon générale par la référence 10, et comporte un corps en plastique moulé 12 dans lequel sont montés une pluralité (par exemple 32) de fourreaux ou douilles de connecteurs électriques femelles 14. Ces douilles 14 sont groupées par paires verticales, une ligne verticale formée par quatre paires telles que 14A-14B, 14C-14D, 14E-14F, 14G-14H, étant associés à l'une des phases du réseau.

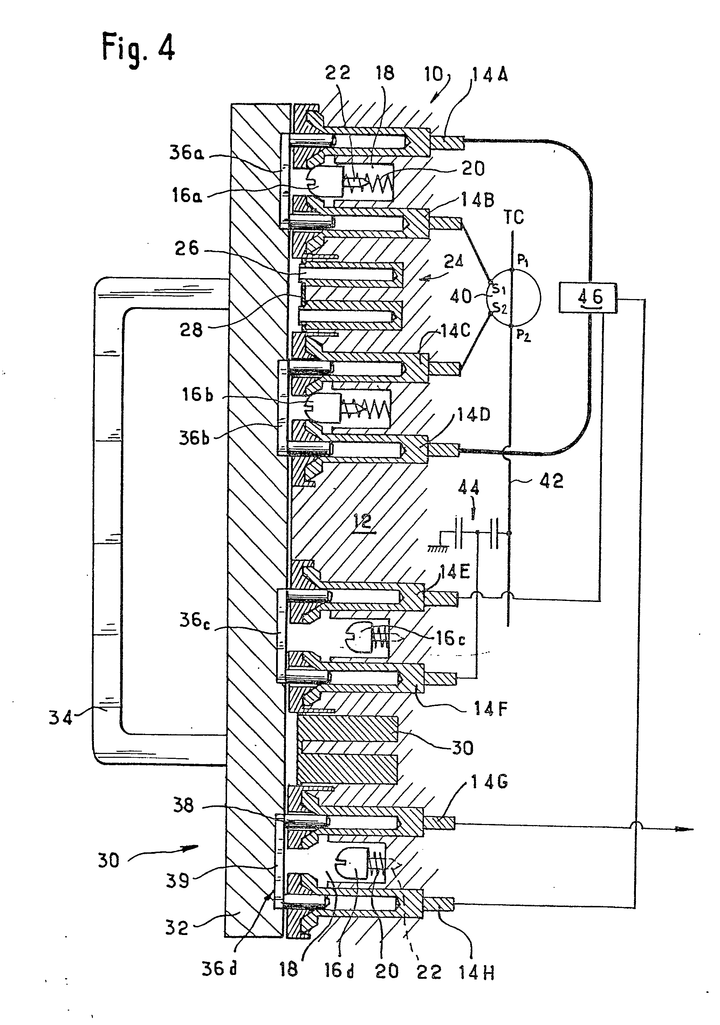

En particulier, les deux paires supérieures 14A-14B et 14C-14D sont associées à un transformateur de courant 40 (voir figure 4) raccordé à un conducteur de phase respectif 42, la paire immédiatement en dessous, 14E-14F, est associée à un transformateur de tension capacitif 44 raccordé au conducteur 12, et la paire la plus basse 14G-14H est associée à un circuit de sortie du relais de protection désigné par la référence 46.

Entre les douilles 14 de chaque paire est prévu un élément de court-circuit 16 dans une chambre 18 qui coopère avec un ressort 20 destiné à solliciter ledit élément de court-circuit 16 vers une position de contact avec les douilles 14. Cependant, chaque élément de court-circuit 16 comporte à sa partie postérieure une portion 22 équipée d'une vis auto-taraudeuse (voir figure 4) grâce à laquelle on peut solidariser à volonté l'élément 16 au corps 12 en faisant tourner la portion 22 à l'aide d'un tournevis engagé dans une fente à sa partie frontale. Les éléments 16c et 16d associés avec les paires de douilles 14E-14F et 14G-14H, sont ainsi immobilisés et inactifs dans l'exemple décrit tandis que les deux éléments supérieurs 16a et 16b ne le sont pas.

Entre les paires de douilles 14A-14B et 14C-14D est prévue une liaison de court-circuit 24 comportant deux douilles 26 couplées par une plaque 28. Cependant, à l'emplacement correspondant entre les paires de douilles 14E-14F et 14G-14H, on a simplement prévu un bouchon neutre 30 ou, alternativement, la cavité correspondante peut être laissée ouverte.

Les bornes S1 et S2 de l'enroulement secondaire du transformateur de courant 40 sont reliées aux douilles 14B et 14C respectivement, tandis que les bornes d'entrée associées du relais 46 sont raccordées aux douilles 14A et 14B. La borne de sortie du transformateur de tension capacitif 44 est reliée à la douille 14F et la borne d'entrée associée du relais 46 est raccordée à la douille 14E. La borne de sortie du relais 46 est reliée à la douille 14H et le disjoncteur ou autre équipement destiné à exploiter le signal de sortie du relais est raccordé à la douille 14G.

Lorsque le relais de protection 46 est en fonctionnement normal, le boîtier 10 est fermé par un couvercle 30, représenté sur la figure 3. En se référant à cette figure, le couvercle 30 comprend une plaque en plastique 32 pourvue d'une poignée 34 sur sa face extérieure et 16 pièces de pontage 36 sur sa face interne. Chaque pièce de pontage 36 possède deux fiches terminales 38 reliées par une traverse 39 et dont la distance correspond à celle des douilles 14 de chacune des seize paires de douille 14 du boîtier 12.

Comme le représente la figure 4, lorsque le couvercle est en position sur le boîtier 10, chaque pièce de pontage 36 est en contact conducteur avec les douilles 14 de la paire respective. Ainsi, le circuit secondaire du transformateur de courant 40 est complété entre ses bornes S1 et S2, par la douille 14B, la pièce de pontage 36a, (laquelle se trouve en parallèle avec l'élément de court-circuitage 24), la douille 14A, le relais 46, la douille 14B, la pièce de pontage 36b et la douille 14C. De même, la borne de sortie du transformateur capacitif de tension 44 est raccordée au relais 46 par l'intermédiaire de la douille 14F, de la pièce de pontage 36c et de la douille 14E et le signal de sortie du relais 46 est appliqué par l'intermédiaire de la douille 14H, la pièce de pontage 36d et la douille 14G.

Lorsque l'on désire essayer le relais 46, on enlève tout d'abord le couvercle 30 du boîtier 10. Ceci a notamment pour effet d'interrompre les liaisons entre les douilles 14E et 14F, et entre les douilles 14G et 14H, en supprimant ainsi l'application de la tension au relais 46 et en isolant le circuit de sortie de ce relais 46 (pour éviter l'émission de signaux de déclenchement parasites vers d'autres équipements pendant la préparation et l'exécution des opérations de test). Cependant, le circuit secondaire du transformateur de courant 40 n'est pas coupé puisque les paires de douilles 14A-14B et 14C-14D restent accouplées par leurs éléments de court-circuit 16a et 16b, maintenant ainsi la continuité du circuit par l'intermédiaire du relais 46. Il faut noter ici que, dans certains cas, il est nécessaire de couper les circuits de déclenchement qui sont commandés par le relais, ou sous le contrôle de ce dernier, avant d'ouvrir le circuit de tension alimentant ce relais; tel est notamment le cas dans les relais de coupure de tension et les relais de minimum d'impédance par exemple. Dans ce cas les éléments de court-circuitage 16 ne sont pas immobilisés au fond des chambres correspondantes pour les entrées de tension du relais et ces circuits de tension ne s'ouvriront alors que sous l'effet de l'insertion de la prise d'essais.

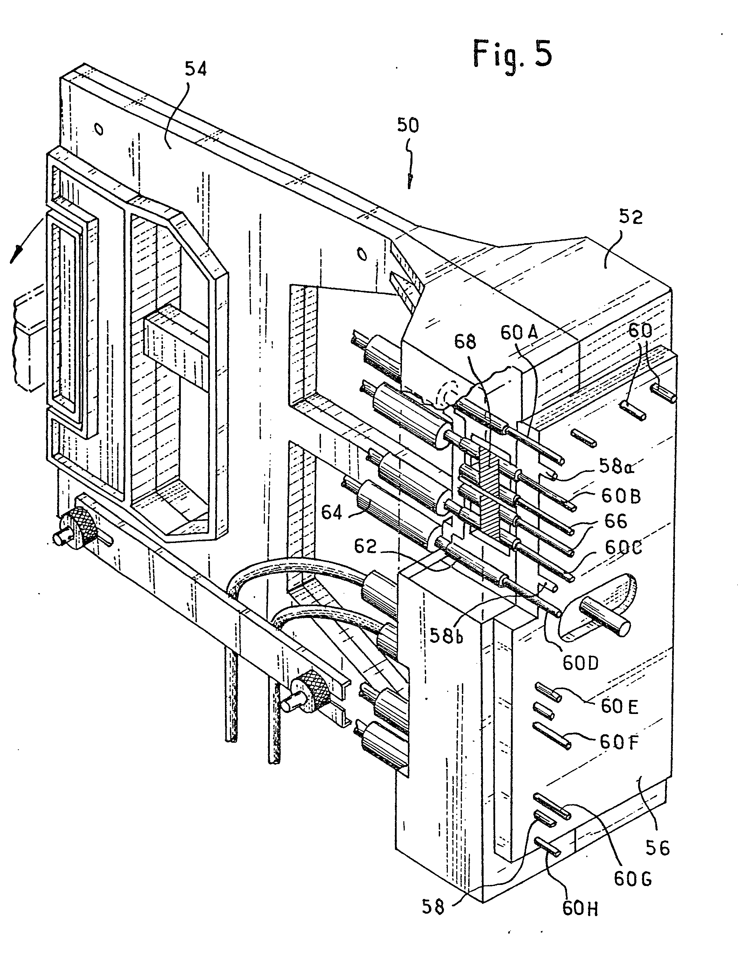

Le branchement du relais 46 pour l'essayer est effectué à l'aide d'une prise d'essai représentée à la figure 5.

En se référant à cette figure, la prise d'essai, désignée d'une manière générale en 50, comporte un corps 52 en un matériau plastique muni d'une poignée 54. Sur la partie frontale de la prise d'essai 50 se trouve une plaque 56 pourvue de plongeurs 58 disposés de façon à correspondre aux chambres 18 du boîtier 10. La plaque 56 est également munie d'ouvertures destinées à recevoir 32 fiches de connecteurs électriques mâles, telles qu'indiquées en 60, qui sont solidaires de la prise d'essai 52 et fixées à cette dernière à l'arrière de la plaque 56 et sont mutuellement espacées de façon à se correspondre avec les douilles 14 du boîtier 10. A sa partie postérieure, chaque fiche 60 est pourvue d'une portion en forme de douille 62 adaptée à recevoir une fiche banane 64. Entre les fiches 60B et 60C se trouvent deux fiches supplémentaires 66 écartées de façon à se correspondre avec les douilles 26 de la liaison de court-circuitage 24 dans le boîtier 10. La fiche 66 occupant la position supérieure est reliée électriquement à la fiche 60B par une tresse métallique 68, et la fiche inférieure 66 est reliée de façon semblable à la fiche 60C.

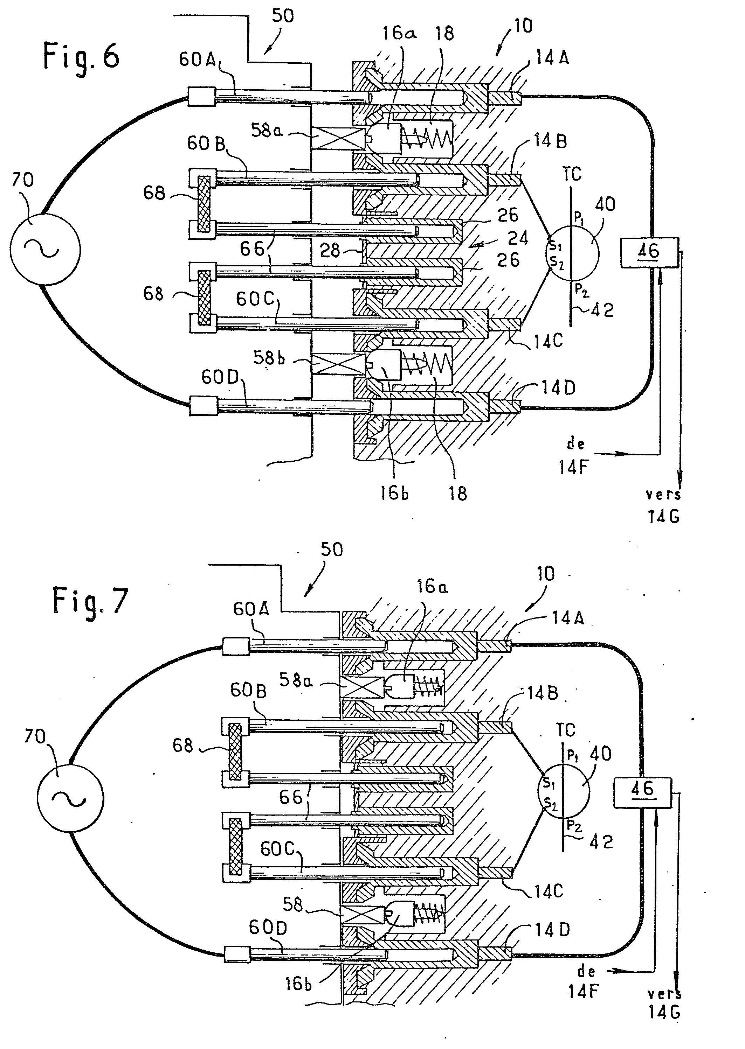

Les fiches 60A et 60D sont reliées par l'intermédiaire de fiches bananes respectives 64 à une source de signal 70 (voir figure 6) pour alimenter les bornes d'entrée du signal de courant dans le relais 46 pendant l'essai; la fiche 60E de la même façon établit une liaison alimentant les bornes d'entrée du signal de tension, et la fiche 60H permet de contrôler le signal de sortie du relais 46.

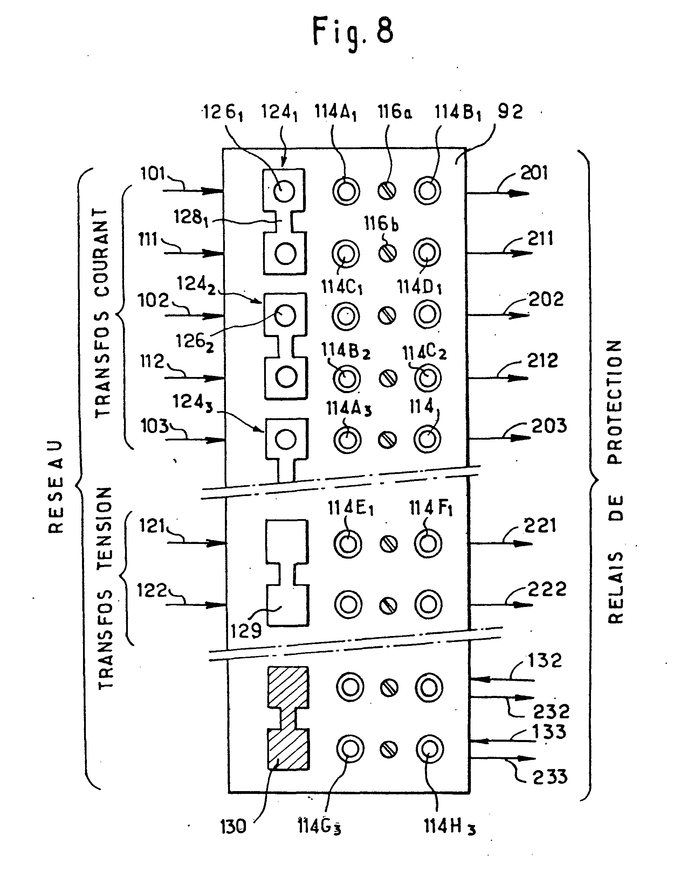

Les fiches 60B, 66 et 60C de la prise de test 50 s'avancent au-delà des fiches 60A, 60B et des plongeurs 58. Ainsi, lorsque la prise d'essai 50 est enfichée progressivement dans le boîtier 10 comme le représente la figure 6, les fiches 60B, 66 et 60C pénètrent les douilles 14B, 26 et 14C avant que tout autre contact ne se produise entre la prise 50 et le boîtier 10. Il en résulte la mise en court-circuit des bornes S1 et S2 du transformateur de courant 40, par l'intermédiaire de la douille 14B, de la fiche 60B, de la tresse 68, de la fiche supérieure 66, de la douille supérieure 26, de la liaison de court-circuit 24, de la plaque 28, de la douille inférieure 26, de la fiche inférieure 66, de la tresse inférieure 68, de la fiche 60C et de la douille 14C. Ensuite, lorsque la prise 50 poursuit sa course dans le boîtier 10, les plongeurs 58a et 58b pénètrent dans les chambres 18, et entrent en contact avec les éléments de court-circuitage 16a et 16b pour couper la liaison entre les douilles 14A et 14B d'une part et les douilles respectives 14B et 14C, d'autre part, interrompant ainsi le branchement du relais 46 et du transformateur de courant 40. Cette interruption se fait sans danger puisque le circuit secondaire du transformateur de courant 40 est déjà fermé par l'intermédiaire des fiches 66 etc. Enfin, lorsque la prise 60 est enfoncée complètement dans le boîtier 10, comme le représente la figure 7, les fiches 60A et 60D établissent le contact avec les douilles 14A et 14D, raccordant la source de signal 70 au relais 46. En même temps, les fiches 60E et 60H (non représentées sur les figures 6 et 7) établissent le contact avec les douilles 14E et 14H pour alimenter l'entrée de signal de tension du relais 46 et pour contrôler son signal de sortie.

Lorsque l'essai est terminé, la prise 50 est retirée, ce qui a pour effet d'inverser la séquence des opérations précédentes, à la fois en ce qui concerne l'ordre et la nature des opérations (branchement/débranchement), concernées.

En particulier, le relais 46 est raccordé à nouveau au transformateur de courant 40 par l'intermédiaire des éléments de court-circuitage 16 avant que le court-circuit effectué par l'intermédiaire des fichess 60B, 66 et 60C soit supprimé. Ensuite, le couvercle 30 eest replacé, rétablissant ainsi les liaisons manquantes avec le relais 46 pour le remettre en service.

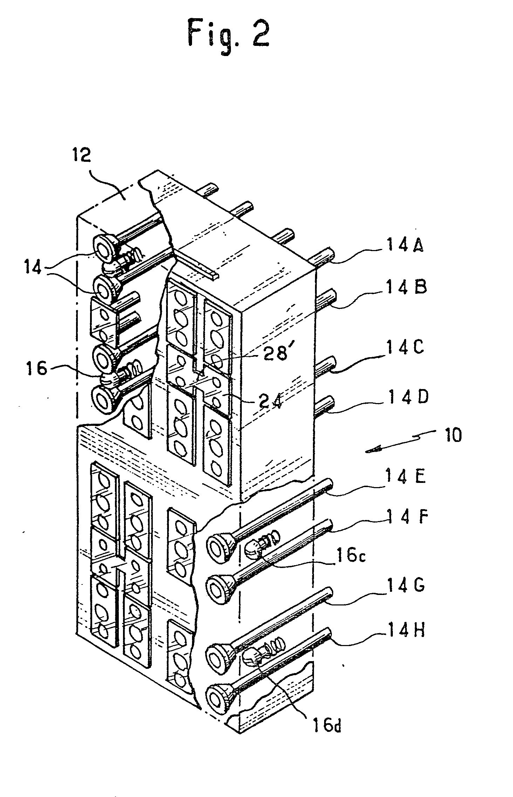

Dans certaines formes de relais de protection, les circuits secondaires des transformateurs de courant 40 ont une extrémité commune pour les différentes phases et cette liaison commune de leur extrémité doit être maintenue pendant l'essai. Cette condition est aisément satisfaite à l'aide de l'équipement de connexion électrique et d'essai décrit ci-dessus en prévoyant une plaque de connexion 28' commune en forme de H pour les liaisons de court-circuit adjacentes 24 comme on l'a représenté en haut et à droite et en bas à gauche de la Figure 2.

Pour l'essai de certains types de relais, il est nécessaire d'interposer un équipement auxiliaire externe dans le circuit secondaire du transformateur de courant 40. Dans un boîtier 10 prévu pour une utilisation avec un tel relais, les liaisons de court-circuitage 24 sont omises et remplacées par un bouchon neutre tel que le bouchon 30 (figure 4). La prise d'essai correspondante 50 est alors modifiée par l'omission des fiches 66 et des tresses 68, et l'équipement externe requis peut alors être connecté entre les fiches 60B et 60C au moyen de fiches bananes 64 insérées dans leurs douilles de connexion respectives 62. Lors de l'insertion de la prise d'essais 50 dans le boîtier 10, l'équipement externe se trouvera alors automatiquement raccordé au transformateur de courant 40 avant que le relais 46 ne soit débranché par rapport à celui-ci. Une prise d'essai 50 modifiée de cette façon peut avantageusement être d'une couleur distinctive, rouge par exemple, pour attirer l'attention sur le fait qu'elle ne saurait être insérée en sécurité sans prendre de précautions supplémentaires dans un boîtier de test 10 du type ordinaire tel que représenté aux figures 1 et 2. Inversement, une prise de test standard 50 telle que celle de la figure 5, qui est en général considérée comme sans danger en toutes circonstances par un opérateur, ne risquerait pas d'être insérée accidentellement dans un boîtier modifié comme on vient de le décrire; en effet, le bouchon neutre remplaçant la liaison de court-circuit 24 empêcherait l'insertion des fiches 66 en s'opposant ainsi à l'accouplement.

Bien entendu, la mise en oeuvre de l'invention n'est pas limitée au mode de réalisation qui vient d'être décrit. En ce qui concerne par exemple l'agencement général du boîtier, on peut le réaliser comme sur la figure 8 où chaque paire de douilles court-circuitables 114 est alignée horizontalement, les paires de douilles étant rangées selon une même bande verticale sur 16 lignes ou davantage.

Selon cette disposition, un boîtier de connexion 92 vu de face sur la figure 8 comporte une paire horizontale de douilles 114A1-114B1 analogues aux douilles 14A et 14B, court-circuitables par un élément 116a analogue à l'élément 16a et une paire de douilles 114C1-114D1, court-circuitables par un élément 116b, cette paire étant disposée immédiatement en dessous de la paire 114A1-114B1. Les douilles 114A1 et 114C1 sont connectées à des conducteurs respectifs d'entrée 101 et 111 reliés aux bornes d'un transformateur de courant associé à une première phase du réseau sur la partie gauche du boîtier 92 et les douilles 114B1 et 114C1 sont reliées au relais de protection sur la droite du boîtier par des conducteurs 201 et 211, respectivement.

Une liaison de court-circuit $124_1$ analogue à la liaison 24 comporte deux douilles $126_1$ alignées chacune avec une des paires 114A1-114B1 et 114C1-114D1 à gauche de ces dernières et reliées par une plaquette conductrice $128_1$

Deux autres groupes de douilles 114A2-114D2 et 114A3-114D3 sont prévues en dessous du groupe 114A1-114D1 avec leurs liaisons de court-circuitage respectives $124_2$ et $124_3$ pour le raccordement de la protection à deux transformateurs de courant respectivement associés aux phases 2 et 3 du réseau par des conducteurs d'entrée et de sortie repérés par des numéros de référence dont le dernier chiffre correspond à la phase à laquelle ils sont associés.

Lè boîtier 92 représenté dans cet exemple comporte également des paires de douilles telles que 114E1-114F1, établissant la liaison entre des transformateurs de mesure de tension prélevées sur le réseau à gauche du boîtier 92 et le ou les relais de protection à droite de ce boîtier, et des paires de douilles telles que 114G3-114H3, sur lesquelles on peut venir prélever les signaux de sortie de la protection grâce à des conducteurs d'aller et retour tels que 132-232 et 133-233.

Toutes ces paires de douilles sont alignées selon la même bande verticale avec sur leur gauche des cavités dans le boîtier, laissées ouvertes telles que 129 ou obturées par des bouchons tels que 130, à la place de liaisons de court-circuit telles que 124.

Toutes les liaisons du boîtier avec le réseau se font sur la gauche de celui-ci et avec le dispositif de protection sur sa droite.

Le couvercle et la prise de test associée au boîtier 92 comportent des éléments enfichables et des poussoirs correspondant à la disposition décrite pour effectuer les opérations de connexion/déconnexion selon le séquencement requis.

REVENDICATIONS

1. Prise d'essai pour un dispositif de connexion électrique dans lequel un premier élément (10) possède une première paire (14B, 14C) d'organes de connexion à un transformateur de courant (40), et une deuxième paire d'organes de connexion (14A, 14D) à un circuit d'exploitation (46) fonctionnant en réponse à ce transformateur de courant chacun des organes de connexion de la première paire étant relié à un organe de connexion correspondant de la deuxième paire par une liaison interruptible (16a, 16b) respective, cette prise d'essai comportant un second élément (50) possédant une première et une deuxième paire d'organes de connexion (60B, 60C et 60A, 60D) agencés pour venir en contact respectivement avec ladite première et seconde paire d'organes de connexion du premier élément lorsque lesdits éléments sont accouplés en fonctionnement, et des moyens (58a, 58b) pour manoeuvrer ladite liaison interruptible, cette prise étant en outre caractérisée en ce qu'elle comporte des moyens de raccordement (66, 68) formant partie intégrante dudit second élément (50) et reliés à la première paire d'organes de connexion de celui-ci pour les raccorder électriquement l'un à l'autre au moins lorsque lesdits premier et second éléments (10 et 50) sont accouplés; et en ce que, lorsque lesdits éléments (10 et 50) sont progressivement accouplés, les premières paires d'organes de connexion (14B, 14C) et (60B, 60C) de chacun de ces éléments entrent d'abord en contact réciproque afin d'établir par l'intermédiaire desdits moyens de raccordement (66, 68) un circuit continu incluant ledit transformateur de courant (40); puis lesdits moyens de manoeuvre (58a, 58b) agissent sur ladite liaison interruptible (16a, 16b) pour interrompre la connexion entre lesdites première (14B, 14C) et seconde (14A, 14D) paires d'organes du premier élément (10); puis les organes de connexion de la seconde paire (14A, 14D et 60A, 60D) de chacun desdits éléments entrent en contact réciproque.

2. Prise d'essai conforme à la revendication 1, caractérisée en ce que lesdits moyens de raccordement comprennent deux éléments conducteurs (66) reliés chacun à un organe de connexion (60B et 60C) respectif de ladite première paire dans le deuxième élément (50) et agencés pour entrer en contact avec un organe de raccord électrique (26, 28) dans ledit premier élément en même temps que lesdites premières paires d'organes de connexion de chacun de ces éléments entrent mutuellement en contact.

3. Dispositif de connexion entre un appareillage électrique et une source de signaux électriques caractérisé en ce qu'il est adapté pour être accouplé et coopérer avec une prise d'essai (50) selon l'une des revendications 1 ou 2.

Fig. 3

Fig. 1

30
32
36
38
39
36a
34
36b
36c
36d

14 A
16a
14B
24
16b
14C
14D
12
14E
14F
14G
14H
16d
20
10

# Fig. 2

12

14

16

14A
14B
28'
14C
24
14D
10
14E
14F
16c
14G
14H
16d

# Fig. 4

Fig. 5

Fig. 6

Fig. 7

# Fig. 8

**Office européen des brevets**

# RAPPORT DE RECHERCHE EUROPEENNE

Numéro de la demande

EP 80 40 1790

| Catégorie | Citation du document avec indication, en cas de besoin, des parties pertinentes | Revendication concernée |
|---|---|---|
| | **DOCUMENTS CONSIDERES COMME PERTINENTS** | |
| A | FR - A - 2 223 852 (AKZONA)<br>* Page 3, ligne 19 - page 7, ligne 17; figures *<br>-- | 1 |
| A | FR - A - 2 342 503 (DELLE-ALSTHOM)<br>* Page 1, ligne 39 - page 2, ligne 36; figures *<br>-- | 1-3 |
| A | DE - A - 2 256 373 (GEYER)<br>* Page 2, dernier alinéa - page 3, alinéa 3; figures *<br>-- | 1 |
| A | US - A - 3 914 564 (SQUARE D)<br>* Colonne 3, ligne 50 - colonne 4, ligne 2; figures *<br>-- | 1 |
| A | FR - A - 1 041 047 (TELESCON)<br>* Résumé; figures *<br>-- | 1 |
| A | DE - C - 599 656 (BBC)<br>* Page 2, lignes 24-57; figures *<br>-- | 1 |
| A | DE - C - 691 333 (SIEMENS-SCHUCKERT)<br>* Page 2, lignes 5-21; figures *<br>-- | 1 |
| A | DE - C - 455 723 (RÜPPEL)<br>* Page 1, lignes 40-52; figures *<br>---- | 1 |

**CLASSEMENT DE LA DEMANDE (Int. Cl. 3)**

H 01 R 29/00
G 01 R 1/20

**DOMAINES TECHNIQUES RECHERCHES (Int. Cl. 3)**

H 01 R 29/00
31/08
13/70
13/703
G 01 R 1/20
1/073
31/02

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

X Le présent rapport de recherche a été établi pour toutes les revendications

| Lieu de la recherche | Date d'achèvement de la recherche | Examinateur |
|---|---|---|
| La Haye | 06-02-1981 | RAMBOER |